Europäisches Patentamt

European Patent Office

Office européen des brevets

(11) Numéro de publication: **0 047 686 B1**

# FASCICULE DE BREVET EUROPEEN

�轴 Date de publication du fascicule du brevet:
14.11.84

(21) Numéro de dépôt: **81401306.6**

(22) Date de dépôt: **14.08.81**

(51) Int. Cl.³: **H 03 D 9/06,** H 01 P 5/22

(54) **Mélangeur hybride hyperfréquence.**

(30) Priorité: **09.09.80 FR 8019414**

(43) Date de publication de la demande:
**17.03.82 Bulletin 82/11**

(45) Mention de la délivrance du brevet:
**14.11.84 Bulletin 84/46**

(84) Etats contractants désignés:
**BE DE GB IT SE**

(56) Documents cités:
**DE - A - 2 525 468
DE - A - 2 819 838
DE - A - 2 944 642
FR - A - 2 241 918
FR - A - 2 395 618
US - A - 3 512 091
US - A - 3 818 385
US - A - 4 186 352**

(73) Titulaire: **LMT RADIO PROFESSIONNELLE, 46-47, Quai Alphonse Le Gallo, F-92103 Boulogne-Billancourt (FR)**

(72) Inventeur: **Marchand, Maurice, THOMSON-CSF SCPI 173 Bld. Haussmann, F-75360 Paris Cedex 08 (FR)**
Inventeur: **Haentjens, Yan, THOMSON-CSF SCPI 173 Bld. Haussmann, F-76360 Paris Cedex 08 (FR)**

(74) Mandataire: **Desperrier, Jean-Louis et al, THOMSON-CSF SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

La présente invention se rapporte aux mélangeurs hybrides hyperfréquence, qui permettent à partir de deux signaux radioélectriques d'obtenir un troisième signal radioélectrique dont la fréquence est égale à la différence de celles des deux premiers signaux. De tels mélangeurs sont particulièrement utiles pour les radars Doppler cohérents dans lesquels tous les signaux sont obtenus à partir d'un oscillateur local à quartz dont la fréquence et la phase sont très stables.

Dans une réalisation particulière d'un tel radar, on utilise dans la chaîne réception un double changement de fréquence. Le premier changement de fréquence s'effectue à l'aide d'un mélangeur recevant d'une part le signal de réception dont la fréquence est comprise entre 9300 et 9900 MHz, et d'autre part un signal issu de la chaîne d'emission et dont la fréquence est comprise entre 7440 et 8040 MHz. Le choix dans ces gammes se fait à l'emission et la différence de fréquence entre ces deux signaux est constante et égale à 1860 MHz.

Cette fréquence est celle du signal résultant de ce mélange et obtenu à la sortie du mélangeur. Elle est relativement élevée et nécessite donc des précautions particulières au niveau de la réalisation du mélangeur pour éviter les pertes et les désadaptations susceptibles d'atténuer par trop le signal à fréquence intermédiaire ainsi obtenu.

Il est connu du document DE-A-2 944 642 de réaliser un mélangeur hybride hyperfréquence comportant un anneau mélangeur de type $\frac{3\lambda}{2}$ relié par deux diodes hyperfréquences à différents guides d'onde qui permettent d'amener les signaux à mélanger et d'extraire le signal résultant du mélange.

Il est également connu du document DE-A-2 819 838 de réaliser un mélangeur hyperfréquence comportant des éléments gravés sur deux couches métalliques distinctes séparées par deux couches diélectriques et une couche métallique formant plan de masse et insérée entre les deux couches diélectriques.

Pour limiter les pertes de couplage et améliorer l'adaptation des organes du mélangeur entre eux, l'invention propose un mélangeur hybride hyperfréquence, du type comprenant un anneau mélangeur du genre $\frac{3\lambda}{2}$, un premier guide d'onde connecté en un premier point sur l'extérieur de cet anneau pour lui amener un premier signal ayant une première fréquence, un deuxième guide d'onde connecté sur l'extérieur de l'anneau en un deuxième point à $\frac{\lambda}{2}$ du premier point pour amener à l'anneau un deuxième signal ayant une deuxième fréquence, ces première et deuxième fréquences déterminant le paramètre $\lambda$, une première et une deuxième diodes connectées d'un côtés sur l'anneau respectivement de part et d'autre du premier point à $\frac{\lambda}{4}$ et de l'autre côté à un troisième guide d'onde qui permet de délivrer un troisième signal dont la fréquence est la différence des première et deuxième fréquences, caractérisé en ce que l'anneau, le premier et le deuxième guides d'onde, sont gravés sur une première couche métallique reposant sur une première couche diélectrique, en ce que le troisième guide d'onde est gravé sur une deuxième couche métallique reposant sur une deuxième couche diélectrique superposée à la première couche diélectrique et séparée de celle-ci par au moins une troisième couche métallique formant plan de masse, en ce que le sandwich formé par ces couches est perforé de deux trous dans lesquels sont logées les deux diodes dont les connexions sont réunies sur le dessus du sandwich à l'anneau, et sur le dessous du sandwich au troisième guide, l'épaisseur du sandwich étant sensiblement égale à celle du boîtier des diodes, en ce qu'il comporte en outre une inductance de choc du type quart-d'onde accordé sur la troisième fréquence, gravée sur la deuxième couche métallique et connectée d'une part au troisième guide d'onde, et d'autre part au plan de masse par l'intermédiaire d'un troisième trou percé dans la deuxième couche diélectrique, et en ce que chaque diode mélangeuse est reliée au troisième guide d'onde par au moins un transformateur d'impédance du type quart-d'onde accordé sur la troisième fréquence, pour adapter l'impédance de la diode à celle du troisième guide; ces transformateurs étant gravés sur la deuxième couche métallique.

D'autres particularités et avantages de l'invention apparaîtront clairement dans la description suivante présentée à titre d'exemple non limitatif et faite en regard des figures annexées suivantes:

la figure 1, qui représente le schéma de principe d'un mélangeur de type connu;

les figures 2 et 3, qui représentent les faces supérieure et inférieure d'un mélangeur selon l'invention;

la figure 4, qui représente la structure en épaisseur d'un tel mélangeur.

Une technoligie courante pour réaliser des circuits hyperfréquence consiste à utiliser une plaque formée d'une couche diélectrique prise en sandwich entre une première couche métallique pleine formant plan de masse, et une deuxième couche métallique sur laquelle on a gravé, par attaque chimique par exemple, des connexions formant des lignes, ou des guides hyperfréquence. L'impédance caractéristique de ces lignes dépend de la largeur des connexions et de la permittivité du diélectrique. La longueur d'onde dans les guides dépend de cette même permittivité. On peut ainsi obtenir des dimensions raisonnables même à de très hautes fréquences, et l'impédance souhaitable pour les liaisons des dipsositifs et de leurs éléments entre eux, en jouant sur cette largeur et cette permittivité. Cette technolgie est aussi connue sous le terme anglo-saxon de «micro-strip».

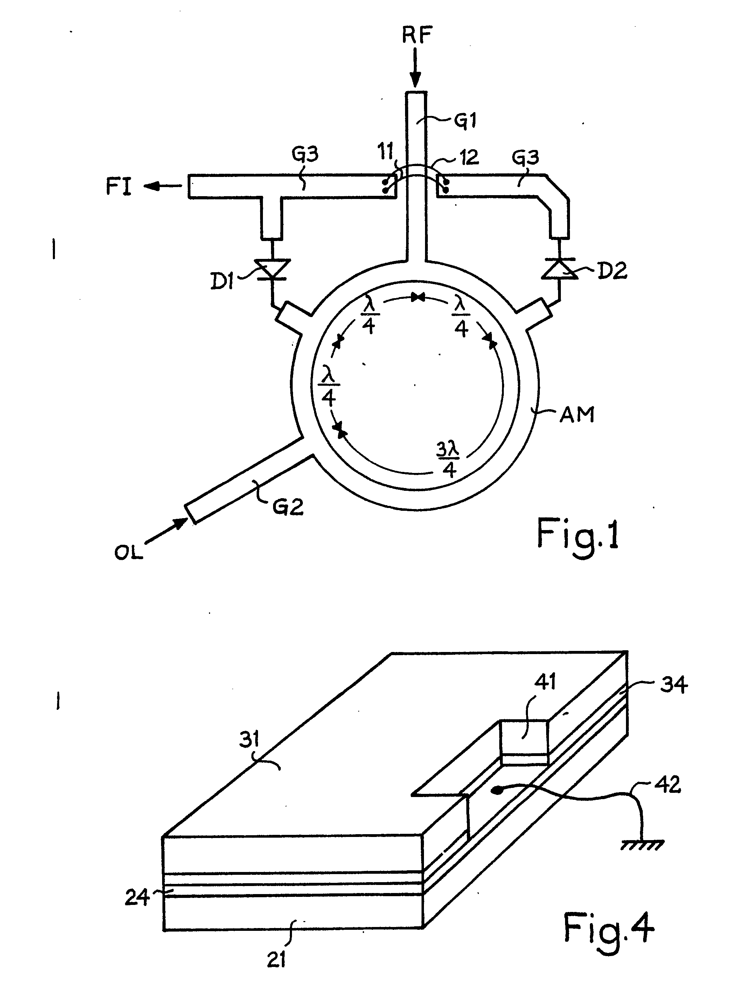

On peut ainsi réaliser un mélangeur tel que celui représente sur la figure 1. Il comprend un anneau AM dont la circonférence mesure trois demi-longueurs d'onde, soit $\frac{3\lambda}{2}$, dans le circuit à une fréquence moyenne entre celle du signal en réception et celle de l'oscillateur local.

Le signal de réception RF est appliqué sur un premier guide d'onde G1 connecté sur l'extérieur de l'anneau AM en un premier point.

Le signal OL de l'oscillateur local est appliqué sur un deuxième guide d'onde G2 connecté sur l'extérieur de l'anneau à une distance égale à $\frac{\lambda}{2}$ du premier point.

Une première diode mélangeuse D1 est connectée par sa cathode sur un court fragment de guide relié à l'extérieur de l'anneau en un point milieu par rapport aux deux guides G1 et G2 et à $\frac{\lambda}{4}$ de ceux-ci.

Une deuxième diode mélangeuse D2 est connectée par son anode sur un autre court fragment de guide relié à l'extérieur de l'anneau en un point situé à $\frac{\lambda}{4}$ de G1 et à $\frac{3\lambda}{2}$ de G2.

L'anode de D1 et la cathode de D2 sont reliées par deux autres courts fragments de guides à un troisième guide G3 à l'extrémité duquel apparaît le signal FI à fréquence intermédiaire résultant du mélange entre les signaux RL et OL.

Dans la disposition représentée sur la figure, il est nécessaire pour permettre le croisement de G1 et de G3 de faire une coupure sur ce dernier. Pour assurer la continuité du guide il faut alors relier les deux lèvres de cette coupure par des moyens tels que les deux fils 11 et 12 représentés sur la figure et qui enjambent G1.

La topologie représentée en figure 1 pour ce type de mélangeur n'est pas unique, et on peut en imaginer d'autres. Mais dans tous les cas il y aura un croisement de deux guides qui nécessitera d'en couper un et de relier les lèvres de la coupure par des moyens tels que les fils 11 et 12.

Selon l'invention, on sépare les circuits situés de part et d'autre des diodes D1 et D2 en les réalisant séparément sur les couches réservées aux guides de deux sandwich métal-diélectrique. On réunit ensuite ces sandwichs en les superposant pour mettre en contact les couches formant plans de masse, et avec une disposition telle que les points de connexion du guide de sortie du signal à fréquence intermédiaire aux diodes mélangeuses coïncident sensiblement avec les points de connexion de ces diodes avec l'anneau. La continuité électrique des plans de masse et l'immobilisation des sandwichs l'un par rapport à l'autre sont obtenues par exemple en soudant ces plans l'un sur l'autre. Pour relier le guide de sortie à l'anneau par les diodes, on perce les sandwichs à l'emplacement des liaisons, et on insère dans ces trous des diodes hyperfréquence en microboîtiers. La largeur d'un tel boîtier est telle qu'elle correspond sensiblement à l'épaisseur des deux sandwichs superposés et que donc les connexions de sortie de ces boîtiers sont au niveau des points auxquels ils doivent être reliés sur les faces gravées des sandwichs.

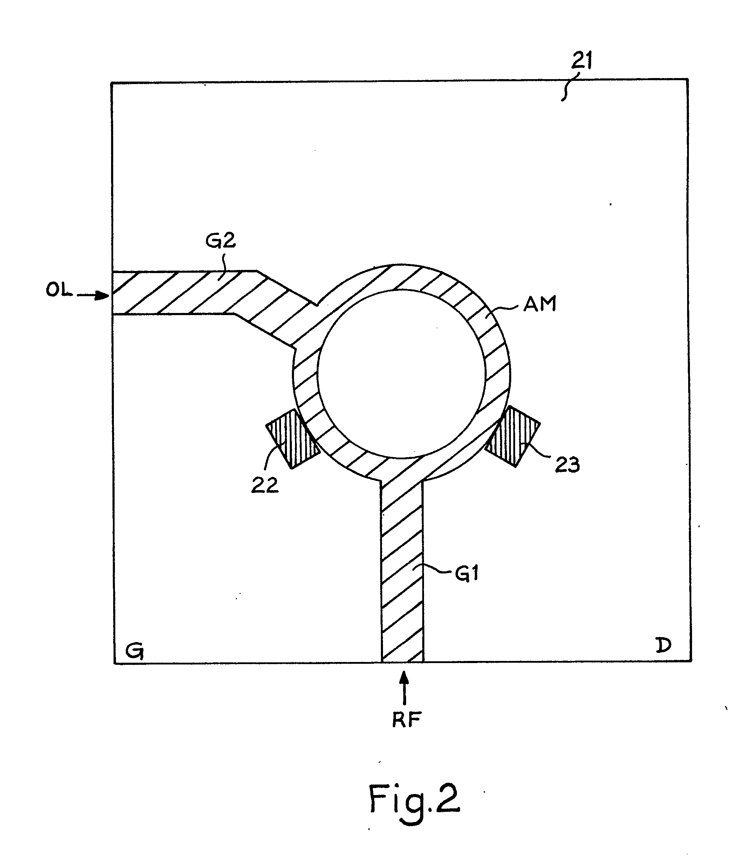

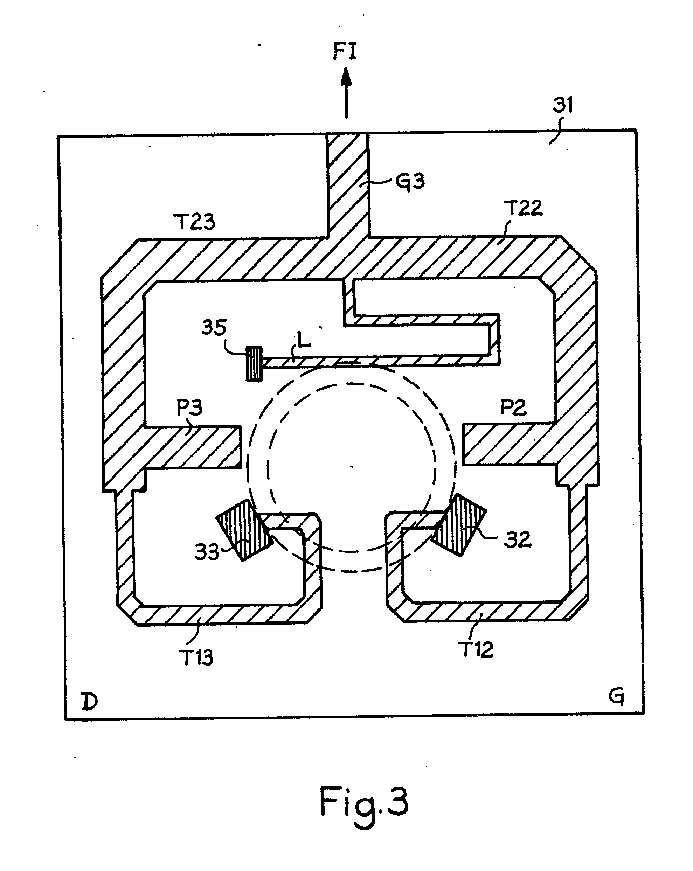

Les deux faces gravées des deux sandwichs utilisés dans une réalisation particulière d'un tel mélangeur ont été représentées sur les figures 2 et 3, dans un sens tel que les lettres D et G soient superposées lorsque ces sandwichs sont accolés dos à dos. Cette réalisation particulière correspond à un mélangeur pouvant fonctionner dans la gamme de fréquence citée plus haut, et le dessin est sensiblement à l'échelle 4 pour un matériau diélectrique dont l'épaisseur est de 0,8 mm et la permittivité relative de 2,2.

La face représentée sur la figure 2 comporte sur la surface d'une plaquette diélectrique 21 de forme sensiblement carrée un anneau AM de dimensions $\frac{3\lambda}{2}$, un guide G1 relié à cet anneau, et un guide G2 relié à l'anneau à une distance de $\frac{\lambda}{2}$ du point de connexion de G1. Les guides G1 et G2 permettent de recevoir respectivement les signaux de réception RF et de l'oscillateur local OL.

Deux trous 22 et 23 sensiblement rectangulaires ont été pratiqués dans l'épaisseur du diélectrique et du plan de masse situé en dessous de celle-ci sur la figure. Ils traversent donc le sandwich de part en part. Ils sont situés de manière à tangenter l'anneau AM en deux points situés de part et d'autre des points de connexion du guide G1 à une distance de $\frac{\lambda}{4}$.

L'autre face gravée représentée sur la figure 3 31 identique à la plaquette 21, un guide G3 et différents circuits d'adaptation. Ce guide G3 permet de délivrer le signal à fréquence intermédiaire FI.

Deux trous 32 et 33 venant se superposer aux trous 22 et 23 sont eux aussi percés dans la plaquette diélectrique et dans le plan de masse situé sous celle-ci. L'anneau AM est représenté par transparence pour bien montrer son emplacement par rapport aux trous 32 et 33.

Les diodes hyperfréquence présentent la forme de deux petits boîtiers parallélépipédiques munis sur deux faces opposées des languettes formant les connexions de sortie. La valeur de la distance entre ces faces opposées est sensiblement la même que celle de l'épaisseur des deux sandwichs lorsqu'ils sont soudés l'un sur l'autre par leurs plans de masse. Les dimensions des trous 22, 23, 32, 33, sont déterminées pour placer ces boîtiers à frottement doux. Il suffit alors de mettre les diodes dans les trous dans le bon sens, et de replier ensuite sur les connexions gravées sur les sandwichs les languettes qui débordent de chaque côté. On termine en soudant sur ces connexions les languettes ainsi repliées.

L'impédance de ces diodes aux fréquences de travail utilisées est d'environ 250 Ω. Pour obtenir un rendement correct du mélangeur, il faut adapter cette impédance à l'impédance du guide G3, qui est de 50 Ω selon une norme très répandue. Comme il y a deux diodes, il faut alors que l'impédance de chacune ramenée au niveau de leur jonction à G3 soit de 100 Ω. Pour obtenir un transformateur du type quart-d'onde donnant ce résultat, il faudrait que l'impédance de celui-ci soit d'environ 158 Ω. La largeur d'un guide ayant cette impédance est faible et amène à de grandes difficultés de réalisation.

Pour éviter ces difficultés, on a utilisé pour chaque diode deux transformateurs quart-d'onde en série qui ramènent dans un premier temps l'impédance à 20 Ω, puis dans un deuxième temps cette impédance de 20 Ω à 100 Ω. Les deux premiers transformateurs pour chaque diode sont respectivement T13 et T12, d'impédance sensiblement égale à 72 Ω, et les deux seconds transformateurs, respectivement T23 et T22, d'impédance sensiblement égale à 44 Ω. Ces transformateurs sont repliés pour occuper moins de place et entourent l'emplacement de l'anneau AM en suivant les côtés de la plaquette 31 pour se joindre à l'extrémité du guide G3 en formant à cet endroit un T.

La dimension longitudinale $(\frac{\lambda}{4})$ des transformateurs est bien entendu calculée à partir de la fréquence du signal FI émis en sortie de G3 puisque c'est le signal utile extrait des diodes. On prend la valeur médiante de la gamme occupée par FI.

Pour éviter qu'à ce signal ne se trouvent superposés des signaux indésirables, on a placé perpendiculairement à T23 et T32, non loin de leurs jonctions avec T13 et T12, deux pièges P3 et P2 qui permettent d'éliminer ces signaux indésirables. Ils sont accordés sur le signal parasite le plus probable, c'est-à-dire sur le signal OL dont le niveau est bien plus important que le signal RF. De plus RF sera quand même atténue puisque sa fréquence n'est pas trop éloignée de celle de OL, et en raison de son faible niveau, il sera aussi éliminé.

Les diodes placées dans les trous 33 et 32 sont polarisées par redressement du signal OL. Pour refermer le circuit électrique on utilise une inductance de choc L réalisée sous la forme d'un fragment de guide de longueur $\frac{\lambda}{4}$ (à la fréquence de FI) dont une extrémité est reliée au point de jonction de G3, T23 et T22, et l'autre à la masse par l'intermédiaire d'un trou 35 percé dans la plaquette 31 et qui permet de la relier, par exemple par une goutte de soudure, au plan de masse situé entre les plaquettes 21 et 31. L'impédance étant nulle (à la fréquence de FI) sur ce plan de masse, elle est infinie à l'autre extrémité, ce qui empêche FI de passer mais laisse passer le courant continu de polarisation.

Cette inductance L est située, ainsi que les pièges P2 et P3 dans l'espace laissé libre au milieu de la plaquette par les transformateurs d'accord des diodes. Elle est repliée pour tenir place dans cet espace.

Il serait assez difficile de prendre un contact de masse sur la tranche des couches métalliques réunies l'une sur l'autre. On a donc représenté sur la figure 4 un moyen d'obtenir aisément un tel contact. Le mélangeur représenté sur cette figure a été limité aux deux sandwichs accolés sans que l'on montre les circuits illustrés par ailleurs aux figures 2 et 3. On a donc deux plaquettes diélectriques 21 et 31 placées l'une sur l'autre avec entre elles les deux couches métalliques 24 et 34 soudées l'une contre l'autre.

Dans le sandwich supérieur, formé de la plaquette 31 et de la couche 34, on a découpé le long du bord une échancrure 41 qui est dans l'exemple illustré de forme rectangulaire. Ceci permet de dégager une partie suffisamment importante de la surface de la couche 24 pour souder un fil de masse 42.

Cette structure ainsi décrite permet donc de n'avoir aucune coupure des circuits hyperfréquence et d'éviter ainsi les ruptures d'impédance que découlent de ces coupures. Dans la réalisation particulière correspondant aux gammes de fréquence citées plus haut, on a pu obtenir une perte de conversion aussi faible que 7 dB.

L'invention s'étend également au cas où l'on utilise comme matériau de départ un sandwich formé de deux couches diélectriques enserrant une seule couche métallique formant plan de masse et recouvertes de deux couches métalliques externes permettant de graver les guides d'ondes. Dans ce cas les couches 24 et 34 sont confondues.

**Revendications**

1. Mélangeur hybride hyperfréquence, du type comprenant un anneau mélangeur (AM) du genre $\frac{3\lambda}{2}$, un premier guide d'onde (G1) connecté en un premier point sur l'extérieur de cet anneau pour lui amener un premier signal ayant une première fréquence, un deuxième guide d'onde (G2) connecté sur l'extérieur de l'anneau en un deuxième point à $\frac{\lambda}{2}$ du premier point pour amener à l'anneau un deuxième signal ayant une deuxième fréquence, ces première et deuxième fréquences déterminant le paramètre $\lambda$, une première et une deuxième diodes (D1, D2) connectées d'un côté sur l'anneau respectivement de part et d'autre du premier point à $\frac{\lambda}{4}$ et de l'autre côté à un troisième guide d'onde (G3) qui permet de délivrer un troisième signal dont la fréquence est la différence des première et deuxième fréquences, caractérisé en ce que l'anneau, le premier et le deuxième guides d'onde, sont gravés sur une première couche métallique reposant sur une première couche diélectrique (21), en ce que le troisième guide d'onde est gravé sur une deuxième couche métallique reposant sur une deuxième couche diélectrique (31) superposée à la première couche diélectrique et séparée de celle-ci par au moins une troisième couche métallique (24) formant plan de masse, en ce que le sandwich formé par ces couches est perforé de deux trous (22, 23) dans lesquels sont logées les deux diodes dont les connexions sont réunies sur le dessus du sandwich à l'anneau, et sur le dessous du sandwich au troisième guide, l'épaisseur du sandwich étant sensiblement égale à celle du boîtier des diodes, en ce qu'il comporte en outre une inductance de choc (L) du type quart-d'onde accordé sur la troisième fréquence, gravée sur la deuxième couche métallique et connectée d'une part au troisième guide d'onde (G3), et d'autre part au plan de masse (34) par l'intermédiaire d'un troisième trou (35) percé dans la deuxième couche diélectrique (31), et en ce que chaque diode mélangeuse est reliée au troisième guide d'onde (G3) par au moins un transformateur d'impédance (T12, T13) du type quart-d'onde accordé sur la troisième fréquence, pour adapter l'impédance de la diode à celle du troisième guide; ces transformateurs étant gravés sur la deuxième couche métallique.

2. Mélangeur selon la revendication 1, caractérisé en ce que chaque diode mélangeuse est reliée au troisième guide d'onde (G3) par deux transformateurs d'impédance (T12, T13, T22, T23) en série du type quart-d'onde accordé sur la troisième fréquence, pour que les largeurs de ces transformateurs soient supérieures à celle d'un transformateur unique; ces transformateurs étant gravés sur la deuxième couche métallique.

3. Mélangeur selon la revendication 2, caractérisé en ce qu'il comprend en outre deux pièges (P2, P3) accordés sur la deuxième fréquence et connectés respectivement sensiblement aux points de jonction des deux transformateurs (T12, T13, T22, T23) reliant les diodes au troisième guide d'onde (G3); ces pièges étant gravés sur la deuxième couche métallique.

4. Mélangeur selon la revendication 3, caractérisé en ce que le sandwich formé par les couches est sensiblement de forme carrée, que l'anneau mélangeur (AM) est situé sensiblement au centre d'une face de ce carré, que les transformateurs quart-d'onde reliant les trous (32, 33) où sont logées les diodes mélangeuses cheminent le long des bords de l'autre face du carré pour rejoindre le troisième guide (G3) en ménageant sur une autre face un espace libre central où sont situés l'inductance de choc (L) et les pièges (P2, P3).

5. Mélangeur selon l'une quelconque des revendications 1 à 4, caractérisé en ce que l'une des couches diélectriques (31) comporte une encoche (41) taillée le long de ses bords pour mettre à nu le plan de masse (24) et permettre la connexion sur celui-ci d'un fil de masse (42).

## Patentansprüche

1. Hybrider Mikrowellenmischer mit einem $\frac{3\lambda}{2}$ - Mischring (AM), einem ersten Wellenleiter (G1), der an einem ersten Punkt des Rings angeschlossen ist und in diesen ein von aussen kommendes erstes Signal einer ersten Frequenz einspeist, einem zweiten Wellenleiter (G2), der an einem zum ersten Punkt einen Abstand von $\frac{\lambda}{2}$ aufweisenden zweiten Punkt des Rings angeschlossen ist und in diesen ein von aussen kommendes zweites Signal einer zweiten Frequenz einspeist, wobei diese erste Frequenz und diese zweite Frequenz den Parameter λ bestimmen, mit einer ersten und einer zweiten Diode (D1, D2), die einerseits an den Ring in einem Abstand von $\frac{\lambda}{4}$ zu je einer der beiden Seiten des erstes Punkts und andererseits an einen dritten Wellenleiter (G3) angeschlossen sind, an dem ein drittes Signal abnehmbar ist, dessen Frequenz gleich der Differenz aus der ersten und der zweiten Frequenz ist, dadurch gekennzeichnet, dass der Ring, der erste Wellenleiter und der zweite Wellenleiter in eine erste Metallschicht graviert sind, die auf einer ersten dielektrischen Schicht (21) liegt, dass der dritte Wellenleiter in eine zweite Metallschicht graviert ist, die über einer auf der ersten dielektrischen Schicht liegenden und von dieser durch mindestens eine dritte Metallschicht (24), die eine Masseebene bildet, getrennten zweiten dielektrischen Schicht (31) liegt, dass die von diesen Schichten gebildete Sandwichanordnung mit zwei Löchern (22, 23) versehen ist, in denen die zwei Dioden sitzen, wobei deren Anschlüsse oberhalb der Sandwichanordnung mit dem Ring und unterhalb der Sandwichanordnung mit dem dritten Wellenleiter verbunden sind und wobei die Dicke der Sandwichanordnung im wesentlichen der Dicke des Gehäuses der Diode entspricht, dass ausserdem eine Schockinduktanz (L) vom Viertelwellentyp, abgestimmt auf die dritte Frequenz, vorgesehen ist, die in die zweite Metallschicht graviert ist und einerseits mit dem dritten Wellenleiter (G3) und andererseits mit der Masseebene (34) über ein drittes Loch (35) verbunden ist, das die zweite dielektrische Schicht (31) durchstösst, und dass jede Mischdiode an den dritten Wellenleiter (G3) über mindestens einen Impedanzwandler (T12, T13) vom Viertelwellentyp, abgestimmt auf die dritte Frequenz, angeschlossen ist, der die Impedanz der Diode an die Impedanz des dritten Wellenleiters anpasst, wobei diese Wandler in die zweite Metallschicht eingraviert sind.

2. Mischer nach Anspruch 1, dadurch gekennzeichnet, dass jede Mischdiode an den dritten Wellenleiter (G3) über zwei Impedanzwandler (T12, T13, T22, T23) in Reihe vom auf die dritte Frequenz abgestimmten Viertelwellentyp angeschlossen ist, damit die Breite dieser Wandler grösser als die eines einzigen Wandlers ist, wobei diese Wandler in die zweite Metallschicht eingraviert sind.

3. Mischer nach Anspruch 2, dadurch gekennzeichnet, dass er ausserdem zwei Fallen (P2, P3) aufweist, die auf die zweite Frequenz abgestimmt und im wesentlichen an den Verbindungspunkten der zwei die Dioden mit dem dritten Wellenleiter (G3) verbindenden Wandler (T12, T13, T22, T23) angeschlossen sind, wobei diese Fallen in die zweite Metallschicht eingraviert sind.

4. Mischer nach Anspruch 3, dadurch gekennzeichnet, dass die von den Schichten gebildete Sandwichanordnung im wesentlichen eine quadratische Form besitzt, dass der Mischring (AM) im wesentlichen im Zentrum einer Seite dieses Quadrats sitzt, dass die Viertelwellenwandler, die an die Löcher (32, 33) anschliessen, in denen die Mischdioden sitzen, entlang der Ränder der anderen Seite des Quadrats verlaufen, um den dritten Wellenleiter (G3) zu erreichen, und dabei auf einer anderen Seite einen zentralen Freiraum belassen, in dem die Schockimpedanz (L) und die Fallen (P2, P3) angeordnet sind.

5. Mischer nach einem beliebigen der Ansprüche 1 bis 4, dadurch gekennzeichnet, dass eine der dielektrischen Schichten (31) einen Ausschnitt (41) entlang ihrer Ränder aufweist, um die Masseebene (24) freizulegen und den Anschluss eines Massedrahts (42) zu ermöglichen.

## Claims

1. An ultra-high frequency hybrid mixer comprising a mixer ring (AM) of the $\frac{3\lambda}{2}$ -type, a first waveguide (G1) connected at a first point to the outside of the mixer ring for feeding a first signal having a first frequency to the ring, a second waveguide (G2) connected at a second point at a distance of $\frac{\lambda}{2}$ from the first point to the mixer ring for feeding a second signal having a second frequency to said ring, said first and second frequencies determining the parameter λ, a first diode (D1) and a second diode (D2) connected on the one hand to the ring on either side of the first point at a distance of $\frac{\lambda}{4}$, and on the other hand to a third waveguide (G3) which is able to deliver a third signal, the frequency of which corresponds to the difference between the first and the second frequency, characterized in that the ring, the first and second waveguides are engraved in a first metal layer located on a first dielectrical layer (21), that the third waveguide is engraved on a second metal layer located on a second dielectric layer (31), the latter being superposed to the first dielectric layer and being separated therefrom by at least a third metal layer (24) which constitutes and earth plane, that the sandwich composed of these layers is perforated by two holes (22, 23) in which the two diodes are positioned, the terminals of the diodes being respectively connected above the sandwich to the ring and below the sandwich to a third guide, the thickness of the sandwich being essentially the same as that of the diodes housing, that it further comprises a shock coil (L) of the quarter wavelength type tuned to the third frequency, this coil being engraved on the second metal layer and being connected on the one hand to the third waveguide (G3) and on the other hand to the earth plane (34) through a third hole (35) which is made in the second dielectric layer (31), and that each mixer diode is connected to the third waveguide (G3) via at least one impedance transformer (T12, T13) of the quarter wavelength type, adjusted to the third frequency in order to adapt the impedance of the diode to the impedance of the third waveguide, these transformers being engraved on the second metal layer.

2. A mixer according to claim 1, characterized in that each mixer diode is connected to the third waveguide (G3) via two impedance transformers (T12, T13, T22, T23) in series connection, of the quarter wavelength type adjusted to the third frequency, such that the width of these transformers is larger than that of a unique transformer, these transformers being engraved on the second metal layer.

3. A mixer according to claim 2, characterized in that it further comprises two traps (P2, P3) adjusted to the second frequency and connected respectively to points which are essentially the junction points of the two transformers (T12, T13, T22, T23) which connect the diodes to the third waveguide (G3), these traps being engraved on the second metal layer.

4. A mixer according to claim 3, characterized in that the sandwich made of the layers is essentially square shaped, that the mixer ring (AM) is located substantially at the centre of one face of said square sandwich, that the quarter wavelength transformers connecting the holes (32, 33) in which the mixer diodes are positioned extend along the edges of the other square face and terminate at the third waveguide (G3), the shock coil (L) and the traps (P2, P3) being situated in the central free space between said transformers on another face of the sandwich.

5. A mixer according to any one of claims 1 to 4, characterized in that one of the dielectric layers (31) comprises a notch (41) which is cut along its edges in order to expose the earth plane (24) and to enable the connection of said plane to an earth wire (42).

Fig.1

Fig.4

7

Fig.2

Fig.3